# EUROPEAN PATENT APPLICATION

(11) **EP 4 664 262 A1**
(43) Date of publication of application: **17.12.2025**
(21) Application number: 23917044.2
(22) Date of filing: 07.09.2023
(51) Int. Cl.: G06F 3/06

(54) **FLASH MEMORY STRIP, MOTHER BOARD AND STORAGE DEVICE**

(30) Priority: 20.01.2023 CN 202310143440
(71) Applicant: Huawei Technologies Co., Ltd., Shenzhen, Guangdong 518129 (CN)
(72) Inventor: LUO, Jinghuai, Shenzhen, Guangdong 518129 (CN); ZHONG, Peiqiang, Shenzhen, Guangdong 518129 (CN); CHEN, Can, Shenzhen, Guangdong 518129 (CN); CHEN, lin, Shenzhen, Guangdong 518129 (CN); LUO, Fei, Shenzhen, Guangdong 518129 (CN)
(74) Representative: Pfenning, Meinig & Partner mbB
(86) International application number: PCT/CN2023/117530
(87) International publication number: WO 2024/152575

(57) **Abstract**

A flash memory stick is provided. The flash memory stick includes a circuit board, at least one storage unit, and a connection port, where the at least one storage unit and the connection port are separately fastened to a surface of the circuit board; and does not include a flash memory main control chip. The at least one storage unit is electrically connected to the connection port through the circuit board. A shape of the circuit board is similar to a shape of an existing memory card. Unlike an SSD, a flash memory no longer needs devices such as a main control chip, a power supply, and a running memory. In comparison with that the SSD implements data reading and writing through chip selection by using a control chip, a chip select signal of a die may be received through the connection port, to implement data reading and writing. Compared with the existing SSD, the flash memory stick has a small volume and low costs, which is conducive to miniaturization development of an electronic device.

## Description

This application claims priority to Chinese Patent Application No. 202310143440.1, filed with the China National Intellectual Property Administration on January 20, 2023 and entitled "FLASH MEMORY STICK, MOTHERBOARD, AND STORAGE DEVICE", which is incorporated herein by reference in its entirety.

### TECHNICAL FIELD

The present invention relates to the field of storage technologies, and in particular, to a flash memory stick, a motherboard, and a storage device.

### BACKGROUND

An existing solid-state drive (SSD) has a large volume and low capacity density, which is not conducive to miniaturization development of an electronic device. Moreover, in addition to a storage unit, an existing storage device also has devices such as a structure housing, a main control chip, and a running memory, which greatly increases costs of the storage device.

### SUMMARY

Embodiments of this application provide a flash memory stick. The flash memory stick includes components such as a circuit board, a storage unit, and a connection port, and does not include components such as a controller of an SSD. The storage unit implements data transmission with an external circuit through the circuit board and the connection port. Compared with the SSD, although the flash memory stick is also a flash memory-based storage, hardware such as a flash memory main control chip is reduced, thereby reducing a volume of the flash memory stick and reducing costs of the flash memory stick. In addition, this application further provides solutions of a motherboard and a storage device that correspond to the flash memory stick.

Therefore, the following technical solutions are used in embodiments of this application.

According to a first aspect, an embodiment of this application provides a flash memory stick, including: a circuit board, including connection circuits and a plurality of pins, where the plurality of pins are electrically connected to the connection circuits; a connection port, disposed at one end of the circuit board and electrically connected to the connection circuits, and configured to receive a chip select signal of a die from an outside of the flash memory stick; and at least one storage unit, fastened to a surface of the circuit board and configured to provide storage space, where the at least one storage unit is electrically connected to the plurality of pins, each storage unit includes a plurality of dies, and a die selected for the chip select signal is configured to provide data access. The flash memory stick does not include a flash memory main control chip.

In this implementation, the flash memory stick includes the circuit board, the at least one storage unit, and the connection port. The at least one storage unit and the connection port are respectively fastened to the surface of the circuit board. The at least one storage unit is electrically connected to the connection port through the circuit board. A shape of the flash memory stick is similar to a shape of an existing memory card. Unlike the SSD, the flash memory stick no longer needs a main control chip (in addition, devices such as a power supply and a running memory may not be included). In comparison with that the SSD implements data reading and writing through chip selection by using the control chip, in this implementation, a chip select signal of a die is received through the connection port, to implement data reading and writing. Compared with the existing SSD, the flash memory stick has a small volume and low costs, which is conducive to miniaturization development of an electronic device.

In an implementation, the at least one storage unit is further configured to receive a current through the connection port, and a voltage of the current is a voltage used to access a plurality of dies of the at least one storage unit.

In this implementation, the storage unit of the flash memory stick receives the current through the connection port, so that devices such as a main control chip and a running memory that control the storage unit to read and write data can be avoided from being disposed on the flash memory stick, to reduce a volume of the flash memory stick.

In an implementation, a physical form of the connection port is adapted to a memory slot.

In this implementation, a physical form of an external interface of the circuit board generally matches a slot of a connector, so that the flash memory stick may be embedded in the slot of the connector, thereby implementing an electrical connection between the flash memory stick and the connector.

In an implementation, the at least one storage unit is fastened to a surface of one side or two sides of the circuit board.

In this implementation, the at least one storage unit is respectively fastened to the surface on one side or two sides of the circuit board, so that more storage units can be fastened to the surface of the circuit board, to improve memory of the flash memory stick.

In an implementation, the storage unit includes a plurality of silicon wafers, the plurality of silicon wafers are stacked on each other, and adjacent silicon wafers are electrically connected to each other through a bonding wire.

In this implementation, the plurality of silicon wafers are stacked on each other, and then fastened to the surface of the circuit board, so that more silicon wafers can be mounted on the circuit board, thereby greatly improving memory of the flash memory stick.

In an implementation, the storage unit is a flash memory medium or a magnetoresistive random access storage medium.

In an implementation, the connection port is an edge connector matching a dual inline memory module connector.

In this implementation, the edge-connector type of connection port is a relatively universal connection port, and may be connected to more connectors. The connection port is set as the edge connector matching the dual inline memory module connector, so that the flash memory stick can be electrically connected to the dual inline memory module connector, and the dual inline memory module connector is a connector with high cost-effectiveness and high universality, which can reduce mounting costs of the flash memory stick.

According to a second aspect, an embodiment of this application provides a motherboard, including: a mechanical part; at least one connector, fastened to the mechanical part and configured to provide a physical interface for inserting or removing a flash memory stick; and at least one control circuit, fastened to the mechanical part and electrically connected to the at least one connector, and configured to send, to the connector, a chip select signal for chip selection on a die of a storage unit.

In this implementation, the flash memory stick and the control circuit are separately assembled, and no mechanical part needs to be used for protection between the flash memory stick and the control circuit. In addition, a volume of the flash memory stick is small, so that a heat dissipation capability of a storage device can be improved.

In an implementation, the connector is a dual inline memory module connector.

In this implementation, the dual inline memory module connector is a connector with high cost-effectiveness and high universality, which can greatly reduce costs of a storage device and improve universality of an accessory.

In an implementation, one control circuit is electrically connected to one or more connectors.

In this implementation, one control circuit may be electrically connected to one or more connectors, so that a quantity of control circuits can be reduced, and costs of the storage device can be reduced.

In an implementation, one connector is electrically connected to a plurality of control circuits.

In this implementation, one connector may be electrically connected to a plurality of control circuits. When one control circuit of the connector is faulty, another control circuit of the connector may manage the connector, thereby improving an error tolerance rate of the storage device.

In an implementation, the connector provides an interface circuit of a solid-state drive SSD.

In an implementation, the motherboard further includes a power module, configured to provide a current to the flash memory stick inserted into the physical interface, where a voltage of the current is a voltage used to access a plurality of dies of the at least one storage unit.

According to a third aspect, an embodiment of this application provides a storage device, including the at least one flash memory stick that may be implemented in the first aspect, and the motherboard that may be implemented in the second aspect, where the flash memory stick is inserted into a physical interface of the motherboard through a connection port for controlling the at least one flash memory stick to read data or write data.

In this implementation, the storage device may be used in an electronic device such as a server, a computing device, a storage system, a workstation, a personal computer, or an outdoor cabinet.

### BRIEF DESCRIPTION OF DRAWINGS

The following briefly describes accompanying drawings that need to be used in the descriptions of embodiments or the prior art.
FIG. 1 is a diagram of a structure of a flash memory stick according to an embodiment of this application;
FIG. 2 is a diagram of pin distribution on a surface of a circuit board according to an embodiment of this application;
FIG. 3 is a diagram of an effect of stack of silicon wafers according to an embodiment of this application;
FIG. 4 is a diagram of a structure of a flash memory stick obtained after a plurality of silicon wafers are stacked according to an embodiment of this application;
FIG. 5 is a diagram of a structure of a storage device according to an embodiment of this application;
FIG. 6 is a diagram of a structure of separating a flash memory stick from a connector according to an embodiment of this application;
FIG. 7 is a diagram of a structure of a flash memory stick fastened to a connector according to an embodiment of this application; and
FIG. 8 is a diagram of a structure of an existing storage device.

### DESCRIPTION OF EMBODIMENTS

The following describes technical solutions in embodiments of this application with reference to the accompanying drawings in embodiments of this application.

In the descriptions of this application, orientations or location relationships indicated by terms "center", "above", "below", "front", "rear", "left", "right", "vertical", "horizontal", "top", "bottom", "inner", "outer", and the like are orientations and location relationships shown based on the accompanying drawings, and are merely intended to facilitate descriptions of this application and simplify descriptions, rather than indicate or imply that an indicated apparatus or element needs to have a specific orientation, and be constructed and operated in the specific orientation. Therefore, the orientation or location relationship cannot be understood as a limitation on this application.

In the descriptions of this application, it should be noted that, unless otherwise expressly specified and limited, terms such as "mount", "interconnect", and "connect" should be understood in a broad sense, for example, may be a fixed connection, a detachable connection, an abutting connection, or an integral connection. A person of ordinary skill in the art may understand specific meanings of the foregoing terms in this application according to specific situations.

In the descriptions of this application, the term "and/or" describes an association relationship between associated objects and represents that three relationships may exist. For example, A and/or B may represent the following three cases: Only A exists, both A and B exist, and only B exists. The character "/" in this specification represents an "or" relationship between associated objects. For example, A/B represents A or B.

In the descriptions of this application, the terms "first", "second", and the like are intended to distinguish between different objects, but do not indicate a specific order of the objects. For example, a first response message, a second response message, and the like are intended to distinguish between different response messages, but do not indicate a specific order of the response messages.

In embodiments of this application, words such as "in an embodiment" or "for example" are used to represent giving an example, an illustration, or a description. Any embodiment or design solution described as "in an embodiment" or "for example" in embodiments of this application should not be explained as being more preferred or having more advantages than another embodiment or design solution. Exactly, use of the word like "in an embodiment" or "for example" is intended to present a related concept in a specific manner.

In the descriptions of this specification, specific features, structures, materials, or characteristics may be combined in an appropriate manner in any one or more embodiments or examples.

A hard disk drive (HDD) is the earliest storage device. The HDD mainly includes components such as a platter, a magnetic head, a platter spindle, a control motor, a head controller, a data converter, an interface, and a cache. The magnetic head inside the HDD can move in a radius direction of the platter. With the platter rotating at a high speed of thousands of rotations per minute, the magnetic head can be positioned at a designated location of the platter for operations such as data reading and data writing. Information is written, by using an electromagnetic flow by changing a polarity of the electromagnetic flow, to a magnetic disk through the magnetic head that is close to a magnetic surface. The information can be read in a reverse way.

With the development of storage technologies, a new generation of storage devices represented by solid-state drives (SSD) emerge. The SSD is a memory driver made of a plurality of solid-state persistent electronic storage chip arrays. The SSD has advantages of fast reading and writing speeds, a light weight, and low power consumption, and gradually replaces the conventional HDD and becomes a mainstream storage device.

Considering compatibility between an HDD and an SSD, SSD manufacturers design a shape of the SSD as a shape of the HDD. In this way, when replacing a storage device of an electronic device, a user may directly remove the HDD inside the electronic device, and then install the SSD in an original slot, so that the SSD can replace the HDD without any obstacles. However, to meet the compatibility, adverse effects also occur. An existing SSD includes a structure housing, a connector, a main control chip, a dynamic random access memory (DRAM), a power supply, and a management peripheral circuit, resulting in a large volume of a storage device and high costs.

To resolve defects of a large volume and high costs of the existing storage device, a flash memory stick (flash-dual inline memory modules, F-DIMM), a motherboard, a storage device, and an electronic device are designed in this application.

Some detachable devices (such as a flash memory main control chip, a power module, and a running memory) that are originally belongs to the SSD are partially or entirely unloaded to the motherboard, and compatibility with the conventional HHD in terms of shape and physical interface form is abandoned. This solution implementation can bring the following benefits: First, a volume of a flash memory is as small as possible, less physical space is occupied, and costs of the flash memory stick is as low as possible. Second, after these detachable devices are moved to the motherboard, a quantity of devices can be reduced, for example, a plurality of flash memory sticks share a same flash memory main control chip or a same power module, which further reduces overall costs. In addition, a structure of the flash memory stick is simpler, and reliability is improved. Moreover, a physical appearance of an interface is in consistent with that of a memory module, so that a memory slot on the market can be directly purchased to produce the motherboard, which brings good compatibility. Finally, a shape of the flash memory stick is similar to that of the memory module, so that the flash memory stick can be mounted in the storage device at high density as the memory module is mounted.

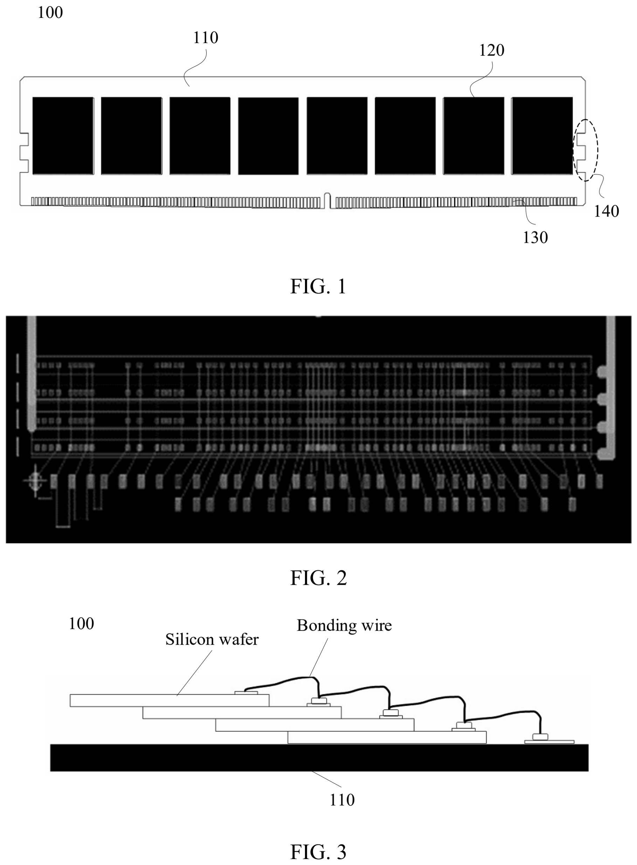

FIG. 1 is a diagram of a structure of a flash memory stick according to an embodiment of this application. As shown in FIG. 1, a flash memory stick 100 includes a circuit board 110, at least one storage unit 120, and a connection port 130. The at least one storage unit 120 is fastened to a surface of the circuit board 110. The connection port 130 is fastened to a side edge of the circuit board 110. The at least one storage unit 120 is electrically connected to the connection port 130 through the circuit board 110.

The circuit board 110 may be a printed circuit board (printed circuit board, PCB), a rigid-flex board, or the like. The circuit board 110 may be a carrier of the at least one storage unit 120 and the connection port 130. Connection circuits are disposed inside or on the surface of the circuit board 110, so that the at least one storage unit 120 may be electrically connected to the connection port 130, and the at least one storage unit 120 can receive a chip select signal of a die outside the flash memory stick 100 through the connection port 130, and the die selected for the chip select signal may be used to provide data access. In an existing SSD, a chip select signal of a die is from a flash memory controller in the SSD. In this embodiment, the flash memory controller is unloaded to a motherboard. Therefore, the chip select signal of the die is from the outside of the flash memory stick, that is, from the motherboard.

In an embodiment, as shown in FIG. 2, at least one connection region is disposed on the surface of the circuit board 110. There are a plurality of pins in each connection region. The plurality of pins in each connection region are electrically connected to connection circuits of the circuit board 110. When the at least one storage unit 120 is respectively disposed in the at least one connection region of the circuit board 110, external pins of the at least one storage unit 120 may be electrically connected to the plurality of pins in the connection region of the circuit board 110 respectively, to facilitate an electrical connection between the at least one storage unit 120 and the connection circuits of the circuit board 110.

In this application, a shape of the circuit board 110 is similar to a shape of an existing memory card (a memory module). A thickness of the circuit board 110 may be a thickness of a conventional PCB or rigid-flex board. A length of the circuit board 110 may be a width of a female connector slot of a dual inline memory modules (dual inline memory modules, DIMM) connector, or a width of a female connector slot of another type of connector. A height of the circuit board 110 is at least greater than a height of one storage unit 120. In an embodiment, a dimension of the circuit board 110 is: thickness×height×length=1.6 mm×31 mm×133 mm.

A physical form of an external interface of the circuit board 110 matches a memory slot. The physical form of the external interface of the circuit board 110 is generally adapted to a slot of a connector, so that the flash memory stick 100 may be embedded into the slot of the connector, thereby implementing an electrical connection between the flash memory stick 100 and the connector. A physical form of an interface provided by the motherboard is consistent with that of a memory, but a circuit in the interface is still consistent with that of the SSD, to facilitate compatibility with an existing flash memory main control chip. Certainly, if necessary, a circuit inconsistent with that of the SSD may alternatively be designed, as long as the flash memory main control chip can identify and manage the flash memory stick.

The circuit board 110 is provided with a fastening assembly 140. The fastening assembly 140 of the circuit board 110 may be coupled to a fastening assembly of an electronic device, so that the circuit board 110 may be fastened inside the electronic device. As shown in FIG. 1, the fastening assembly 140 may be grooves on two sides of the circuit board 110. The circuit board 110 is embedded into a female connector slot of a connector of the electronic device, and fastening assemblies of the female connector slot of the connector of the electronic device are embedded into the grooves on the two sides of the circuit board 110, so that the flash memory stick 100 is fastened inside the electronic device. Compared with an existing SDD structure, the flash memory stick 100 does not need to be fastened through a handle strip, which can reduce costs of the flash memory stick 100.

The storage unit 120 is a device that can store data, and may be a capacitive storage, a resistive storage, or the like. The capacitive storage may be a not and flash (not and flash, NAND Flash) medium, a phase change memory (PCM) medium, a magnetoresistive random access memory (MRAM) medium, or another non-volatile memory. The storage unit 120 includes a plurality of dies. A die that is in the storage unit 120 and that is selected for the chip select signal is configured to provide data access, to implement data reading and writing.

In an embodiment, a power module of the motherboard has completed a power operation such as voltage conversion. Therefore, after the flash memory stick receives a current, the storage unit may be directly accessed without requiring a power operation such as voltage conversion. The storage unit 120 receives a current through the connection port 130. A voltage of the current is a voltage used to perform reading and writing on the plurality of dies of the at least one storage unit 120. The storage unit 230 of the flash memory stick 100 receives the current through the connection port, so that devices such as a main control chip and a running memory that control the storage unit to read and write data can be avoided from being disposed on the flash memory stick, to reduce a volume of the flash memory stick 100. A medium of the running memory is, for example, a RAM. When reading and writing data on the die of the storage unit in the flash memory stick, the RAM is configured to cache the read and written data.

In this application, the at least one storage unit 120 is separately fastened to a surface on one side or surfaces on two sides of the circuit board 110, so that more storage units 120 can be mounted on the circuit board 110, to improve memory of the flash memory stick 100. In addition, a surface of the at least one storage unit 120 is attached to the surface of the circuit board 110, so that a contact region between the surface of the storage unit 120 and the outside can be increased, to improve a heat dissipation capability of the storage unit 120.

When the storage unit 120 is a packaged silicon wafer, the storage unit 120 may be fastened to the surface of the circuit board 110 in a tiled manner. When the storage unit 120 is an unpackaged silicon wafer, a plurality of silicon wafers may be fastened to the surface of the circuit board 110 in a tiled manner. Alternatively, the plurality of silicon wafers are stacked on each other to form a package, and then the plurality of stacked silicon wafers are fastened to the surface of the circuit board 110 in a tiled manner. After the plurality of silicon wafers are mounted on the circuit board 110, the plurality of silicon wafers are packaged. In this application, an integrated packaging technology may be used for the flash memory stick 100. After silicon wafer dots are connected to the pins of the circuit board 110, overall plastic package is performed. This can reduce a manufacturing process, improve a heat dissipation capability of the flash memory stick 100, and reduce costs of the flash memory stick 100.

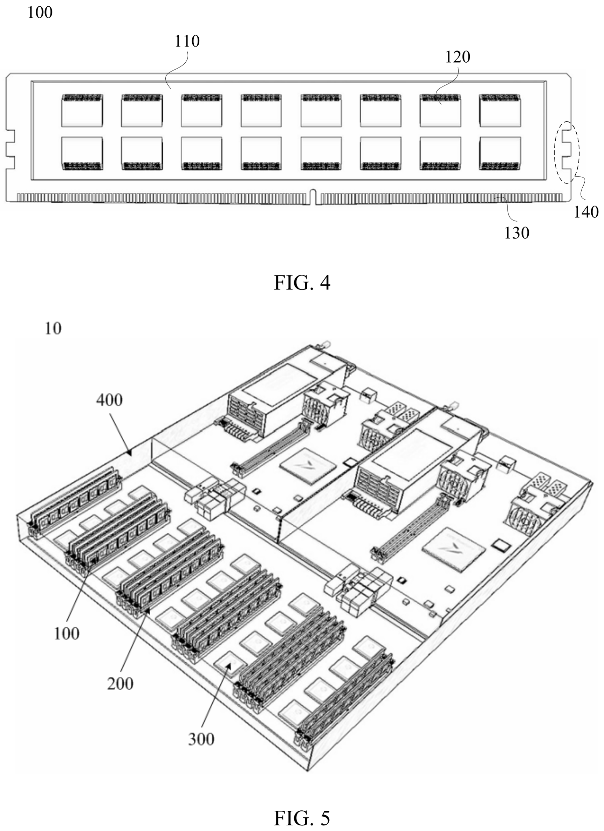

In an embodiment, as shown in FIG. 3, when the plurality of silicon wafers are stacked on each other, a part that is of each silicon wafer and that is provided with an external pin is exposed to the outside. Adjacent silicon wafers (specifically, external pins on the silicon wafers) may be electrically connected (for example, in series) through a bonding wire. A silicon wafer located at a bottom layer is connected to a packaged external interface through a bonding wire. An external pin on the silicon wafer on the surface of the circuit board 110 is electrically connected to a pin of the circuit board 110 through a bonding wire, so that the plurality of stacked silicon wafers are electrically connected to the circuit board 110. The plurality of silicon wafers are stacked on each other, and are fastened to the connection region of the circuit board 110, to obtain the flash memory stick 100 shown in FIG. 4. In this application, the plurality of silicon wafers are stacked on connection regions of the circuit board 110, so that more storage units 120 can be mounted on the circuit board 110, to further improve a memory capacity of the flash memory stick 100. The bonding wire may be a gold wire or a silver wire.

The connection port 130 is disposed on the surface of the circuit board 110, and is located on a side edge of one side of the circuit board 110. One side of the circuit board 110 is embedded into the female connector slot of the connector, the connection port 130 is electrically connected to the connector, and the at least one storage unit 120 is electrically connected to another electronic device, to implement data transmission between the at least one storage unit 120 and the another electronic device. In this application, the connection port 130 may be an edge connector including a plurality of pins or another type of connection port.

The edge connector may be a male connector of the DIMM connector, one side of the circuit board 110 is embedded into a female connector slot of the DIMM connector, and the male connector of the DIMM connector of the circuit board 110 is coupled to the female connector slot of the DIMM connector, to implement an electrical connection between the flash memory stick 100 and the DIMM connector.

In an embodiment, the pins of the connection port 130 are redefined as follows:

| Signal Type | Use | Wire bonding | DIFM |
|---|---|---|---|
| DQS_T | Nand-data gating signal | 4 dies directly connected in series | DQS_T |
| DQS_C | Nand-data gating complementary signal | 4 dies directly connected in series | DQS_C |
| DQ | Nand-data signal | 4 dies directly connected in series | DQ |
| RB | Nand-busy/idle status signal | No use and no wiring | None |
| CLE | Nand-command latch signal | 4 dies directly connected in series | CLE |
| ALE | Nand-address latch signal | 4 dies directly connected in series | ALE |
| RE_T | Nand-read enable signal | 4 dies directly connected in series | RE_T |
| RE_C | Nand-read enable complementary signal | 4 dies directly connected in series | RE_C |
| WE_C | Nand-write enable signal | 4 dies directly connected in series | WE_C |
| WP | Nand-write protection signal | 4 dies directly connected in series | WP |
| ZQ | Nand-ZQ calibration signal | 4 dies directly connected in series | ZQ |
| CE | Nand-chip select signal | die 1 and die 2 are connected, die3, die 4, and NC 53 are connected | CE0; CE1 |
| MDS | Nand-multi-DIE stack configuration signal | For details about a special processing manner, refer to a wire sequence attachment | MDS0; MDS1 |
| VCC/VCCQ /VPP/VREFQ | Nand-power signal | 4 dies directly connected in series | VCC/VCCQ /VPP/VREFQ |
| VSS/VSSQ | Nand-GND | 4 dies directly connected in series | VSS/VSSQ |
| NU | No use | No use and no wiring | None |
| NC | No connection | No wiring (special for NC 53), and for details, refer to a wire sequence attachment | None |

In this embodiment of this application, the flash memory stick 100 includes only the circuit board 110, the at least one storage unit 120, and the connection port 130. The at least one storage unit 120 is fastened to the surface of the circuit board 110. The connection port 130 is fastened to the side edge of the circuit board 110. The at least one storage unit 120 is electrically connected to the connection port 130 through the circuit board 110. The shape of the circuit board 110 is similar to the shape of the existing memory card. Unlike the SSD, the flash memory stick 100 no longer needs devices such as a main control chip, a power supply, and a running memory. In comparison with that the SSD implements data reading and writing through chip selection by using the control chip, in this implementation, a chip select signal of a die may be received through the connection port, to implement data reading and writing. Compared with the existing SSD, the flash memory stick 100 in this application has a small volume and low costs, which is conducive to miniaturization development of an electronic device.

In addition, the flash memory stick 100 has no connector and no mechanical part, and may not need a back plate of an all flash array (all flash array, AFA) frame. Compared with an existing SDD structure, the flash memory stick 100 may be implemented in a 1U slot of a chassis, and the flash memory stick 100 has made significant improvements in terms of hardware costs, density, heat dissipation, and evolution capabilities.

FIG. 5 is a diagram of a structure of a storage device according to an embodiment of this application. As shown in FIG. 5, the storage device 10 includes a plurality of flash memory sticks 100, a plurality of connectors 200, a plurality of control circuits 300, and a mechanical part 400. The plurality of connectors 200, the plurality of control circuits 300, and the mechanical part 400 can form a motherboard. The motherboard may be used as an intermediate, so that the plurality of flash memory sticks 100 are mounted and electrically connected to the storage device 10.

In this application, the flash memory stick 100 is the flash memory stick 100 shown in FIG. 1 to FIG. 4.

In this application, the connector 200 may be a female connector slot of a DIMM connector, for example, a female connector slot of a double data rate (double data rate, DDR) 4 DIMM connector, a female connector slot of a DDR5 DIMM connector, or a female connector slot of another type of connector. This is not limited in this application. Preferably, a DIMM connector is selected in this application. The DIMM connector is a connector with high cost-effectiveness and high universality, which can greatly reduce costs of the storage device 10 and improve universality of an accessory. For example, if a transmission rate of the DDR4 DIMM connector is 5 Gbps, costs are very low.

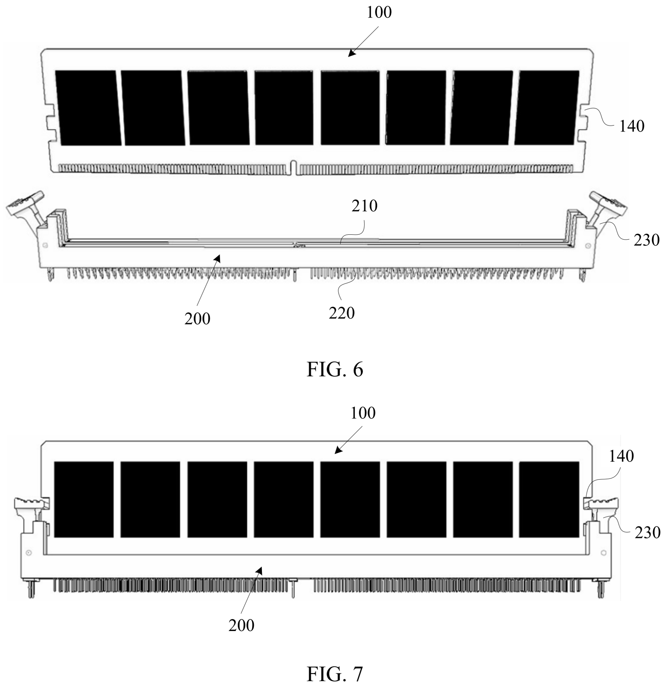

As shown in FIG. 6, a connector 200 includes a female connector slot 210, a plurality of pin ports 220, and at least one fastening assembly 230. Pins on an inner side of the female connector slot 210 are electrically connected to the plurality of pin ports 220. The female connector slot 210 may be coupled to the flash memory stick 100. The plurality of pin ports 220 may be coupled to sockets inside the storage device 10. The connector 200 provides a physical interface for inserting or removing the flash memory stick, so that the flash memory stick 100 may be electrically connected to the storage device 10, to implement data transmission between the flash memory stick 100 and a circuit of the storage device 10. In an embodiment, the connector 200 provides an interface circuit of an SSD.

The fastening assembly 230 of the connector 200 may be movably fastened to an outer side of the female connector slot 210 of the connector 200. Generally, the fastening assembly 230 rotates to a side away from the female connector slot 210, so that the flash memory stick 100 can be embedded into the female connector slot 210. As shown in FIG. 7, when the flash memory stick 100 is embedded into the female connector slot 210, the fastening assembly 230 rotates to a side close to the female connector slot 210, and can be coupled to a fastening assembly 140 of the flash memory stick 100, so that the flash memory stick 100 is fastened to the connector 200, thereby avoiding poor contact between the flash memory stick 100 and the connector 200.

In this application, the control circuit 300 is fastened inside the mechanical part 400. The control circuit 300 includes a connector, a main control chip, a DRAM, a power supply, and a management peripheral circuit, and is configured to send, to the connector, a chip select signal for chip selection on a die of the storage unit 120. The plurality of connectors 200 are electrically connected to the plurality of control circuits 300 respectively. The control circuit 300 sends the chip select signal of the die to the flash memory stick 100 through the connector 200, so that the flash memory stick 100 reads data and writes data. A management chip, a connector, a DRAM, a power supply, and a management peripheral circuit of the storage unit 120 are centrally designed on the mechanical part 400, so that the control circuit 300 is separated from the flash memory stick 100, thereby reducing a failure rate and costs of the storage device 10.

In an embodiment, one control circuit 300 may be electrically connected to one or more connectors 200, so that a quantity of control circuits 300 can be reduced, and costs of the storage device 10 can be reduced.

In an embodiment, one connector 200 may be electrically connected to one or more control circuits 300. When one control circuit 300 of the connector 200 is faulty, another control circuit 300 of the connector 200 may manage the connector 200, thereby improving an error tolerance rate of the storage device 10.

A height of the flash memory stick 100 is higher than a height of the control circuit 300. A top-view area of the flash memory stick 100 is less than a top-view area of the control circuit 300. The plurality of connectors 200 and the plurality of control circuits 300 may be fastened inside the mechanical part 400 in a mutually spaced manner, to avoid the plurality of flash memory sticks 100 gathering together and generating a large amount of heat that is difficult to dissipate. In an embodiment, as shown in FIG. 5, four connectors 200 are arranged side by side. Four control circuits 300 are arranged side by side in an extension direction of the connector 200. The four connectors 200 and the four control circuits 300 are fastened inside the mechanical part 400 in a mutually spaced manner.

When an actual product is constructed, the storage unit 120 of the flash memory stick 100 uses a NAND flash as a storage medium. In this application, an AFA is reconstructed, and a NAND flash is separately made into an F-DIMM by decoupling the NAND flash from another circuit, thereby reducing hardware costs of an entire device structure, a circuit, and a connector, reducing production and assembly costs, and supporting AFA hardware cost reduction by more than 30%.

In this embodiment of this application, the flash memory stick 100 and the control circuit 300 are separately fastened inside the storage device 10. No mechanical part protection is needed between the flash memory stick 100 and the control circuit 300. In addition, a volume of the flash memory stick 100 is small, so that a heat dissipation capability of the storage device 10 can be improved.

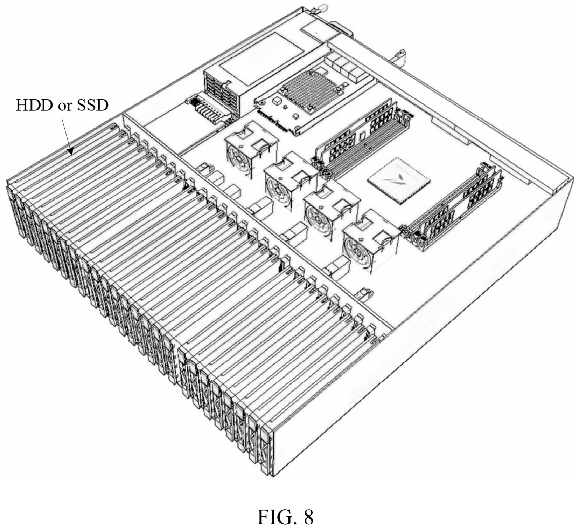

As shown in FIG. 8, a storage module of the existing storage device is an SSD. A volume of the SSD is larger than the volume of the flash memory stick 100. A plurality of SSDs are arranged side by side and fastened inside the storage device. Compared with the storage device 10 shown in FIG. 5, the plurality of SSDs of the existing storage device are close to each other. As a result, it is difficult to dissipate heat inside the existing storage device, and a heat dissipation capability of the existing storage device is far lower than that of the storage device 10 shown in FIG. 5. In addition, the flash memory stick 100 has no mechanical part and has a small volume, so that a heat dissipation device is not needed for cooling, thereby reducing costs of the storage device 10.

An embodiment of this application provides an electronic device. The electronic device includes at least one flash memory stick. The flash memory stick may be the flash memory stick 100 shown in FIG. 1 to FIG. 4. Because the electronic device includes the flash memory stick 100 shown in FIG. 1 to FIG. 4, the electronic device has all or at least some advantages of the flash memory stick 100. The electronic device may be a server, a computing device, a storage system, a workstation, a personal computer, an outdoor cabinet, or the like.

An embodiment of this application provides an electronic device. The electronic device includes at least one storage device. The storage device may be the storage device 10 shown in FIG. 5. Because the electronic device includes the storage device 10 shown in FIG. 5, the electronic device has all or at least some advantages of the storage device 10. The electronic device may be a server, a computing device, a storage system, a workstation, a personal computer, an outdoor cabinet, or the like.

A quantity of components of the storage device, a location relationship between the components, a type of the components, a shape of the components, and the like provided in embodiments of this application are not limited to the foregoing embodiments. All technical solutions implemented based on a principle of this application fall within the protection scope of this solution. For any one or more embodiments or figures in the specification, technical solutions combined in a proper manner fall within the protection scope of this solution.

A quantity of components, a location relationship between the components, a type of the components, a shape of the components, and the like of the electronic device provided in embodiments of this application are not limited to the foregoing embodiments. All technical solutions implemented based on a principle of this application fall within the protection scope of this solution. For any one or more embodiments or figures in the specification, technical solutions combined in a proper manner fall within the protection scope of this solution.

Finally, it is noted that the foregoing embodiments are merely used to describe the technical solutions of this application. A person of ordinary skill in the art should understand that, although this application is described in detail with reference to the foregoing embodiments, the technical solutions described in the foregoing embodiments may still be modified, or some technical features thereof may be equivalently replaced. Such modifications or replacements do not make the essence of the corresponding technical solutions depart from the spirit and scope of the technical solutions of embodiments of this application.

## Claims

1. A flash memory stick, comprising:
a circuit board (110), comprising connection circuits and a plurality of pins, wherein the plurality of pins are electrically connected to the connection circuits;
a connection port (130), disposed at one end of the circuit board and electrically connected to the connection circuits, and configured to receive a chip select signal of a die from an outside of the flash memory stick; and
at least one storage unit (120), fastened to a surface of the circuit board and configured to provide storage space, wherein the at least one storage unit is electrically connected to the plurality of pins, each storage unit comprises a plurality of dies, and a die selected for the chip select signal is configured to provide data access.

2. The flash memory stick according to claim 1, wherein the at least one storage unit is further configured to receive a current through the connection port, and a voltage of the current is a voltage used to access a plurality of dies of the at least one storage unit.

3. The flash memory stick according to claim 1 or 2, wherein a physical form of the connection port is adapted to a memory slot.

4. The flash memory stick according to any one of claims 1 to 3, wherein the at least one storage unit is fastened to a surface of one side or surfaces of two sides of the circuit board.

5. The flash memory stick according to any one of claims 1 to 4, wherein each storage unit comprises a plurality of silicon wafers, the plurality of silicon wafers are stacked on each other, and adjacent silicon wafers are electrically connected to each other through a bonding wire.

6. The flash memory stick according to any one of claims 1 to 5, wherein the storage unit is a flash memory medium or a magnetoresistive random access storage medium.

7. The flash memory stick according to any one of claims 1 to 6, wherein the connection port is an edge connector matching a dual inline memory module connector.

8. A motherboard, comprising:
a mechanical part (400);
at least one connector (200), fastened to the mechanical part and configured to provide a physical interface for inserting or removing a flash memory stick; and
at least one control circuit (300), fastened to the mechanical part and electrically connected to the at least one connector, and configured to send, to the connector, a chip select signal for chip selection on a die of a storage unit.

9. The motherboard according to claim 8, wherein the connector is a dual inline memory module connector.

10. The motherboard according to claim 8 or 9, wherein one control circuit is electrically connected to one or more connectors.

11. The motherboard according to claim 8 or 9, wherein one connector is electrically connected to a plurality of control circuits.

12. The motherboard according to any one of claims 8 to 11, wherein the connector provides an interface circuit of a solid-state drive SSD.

13. The motherboard according to claim 8 or 9, further comprising a power module, configured to provide a current to the flash memory stick inserted into the physical interface, wherein a voltage of the current is a voltage used to access a plurality of dies of the at least one storage unit.

14. A storage device, comprising:
the flash memory stick according to any one of claims 1 to 7; and
the motherboard according to any one of claims 8 to 13, configured to control at least one of the flash memory sticks to read data or write data, wherein the flash memory stick is inserted into a physical interface of the motherboard through a connection port.
